# EUROPÄISCHE PATENTSCHRIFT

(11) **EP 0 673 804 B1**
(45) Veröffentlichungstag und Bekanntmachung des Hinweises auf die Patenterteilung: **16.07.1997**
(21) Anmeldenummer: 95103012.1
(22) Anmeldetag: 03.03.1995
(51) Int. Cl.: B60R 11/00, B60R 16/02, B60R 11/02, H05K 5/02

(54) **Anordnung zum Befestigen eines elektronischen Registriergerätes**
Arrangement for fixing an electronic registering device
Dispositif de fixation d'un appareil d'enregistrement électronique

(30) Priorität: 16.03.1994 DE 9404411 U
(43) Veröffentlichungstag der Anmeldung: 27.09.1995
(73) Patentinhaber: VDO Adolf Schindling AG, 60326 Frankfurt/Main (DE)
(72) Erfinder: Straub, Dietmar Dr., D-78056 Villingen-Schwenningen (DE); Hautvast, Heinz-Josef, Dipl.-Ing. (FH), D-78086 Brigachtal (DE); Modest, Otmar, Dipl.-Ing. (FH), D-78078 Niedereschach (DE)

(56) Entgegenhaltungen:
- EP-A- 0 365 904
- EP-A- 0 531 854
- US-A- 5 193 890

## Beschreibung

Die Erfindung betrifft eine Anordnung zum Befestigen eines elektronischen Registriergerätes mit Mitteln zum verhindern der Entnahme des Registriergerätes bei nicht unterbrochener Stromversorgung nach dem Gattungsbegriff des Anspruchs 1.

Registriergeräte, die der Unfalldatenerfassung, beispielsweise in Kraftfahrzeugen, dienen, sind unter anderem mit Beschleunigungssensoren ausgerüstet, deren Signale daraufhin ausgewertet werden, ob an dem betreffenden Fahrzeug ein unfallrelevanter Stoß erfolgt ist und demzufolge ein zeitbasiertes Festspeichern von Fahr- und Zustandsdaten des Fahrzeuges ausgelöst werden muß.

Um eine datengesicherte Auswertung eines derartigen Unfall-Registriergerätes vornehmen zu können, ist es erforderlich, daß das Registriergerät In dem betreffenden Fahrzeug ausbaufähig angebracht ist, also eine gewisse Zugänglichkeit gegeben sein muß. Auf der anderen Seite sollte für ein derartiges Registriergerät aus ästhetischen Gründen eine unauffällige Anordnung angestrebt werden, allerdings in einem möglichst knautschsicheren Bereich des Fahrzeuges. Bei diesen sich widersprechenden Bedingungen kommt als Einbauort im wesentlichen nur der Fahrzeugboden unter dem Fahrer- bzw. dem Beifahrersitz oder den Rücksitzen in Betracht. Diese Anordnungssituation erschwert aber den nach einem Unfall zur Sicherung der aufgezeichneten Daten erforderlichen Ausbau des Registriergerätes erheblich. Hinzu kommt, daß der Ausbau gegebenenfalls von einem Laien vorgenommen wird und außerdem eine Paniksituation gegeben sein kann. D. h. es besteht, wenn die Stromversorgung des Registriergerätes nicht zuvor unterbrochen wird, die Gefahr, daß beim Ausbau und der Entnahme des Registriergerätes insbesondere durch Anstoßen des Registriergerätes Speicherungen erfolgen, welche Stöße am Fahrzeug vortäuschen, unter Umständen auch Überschreibungen von zuvor erfolgten Speicherungen, wenigstens von solchen, die im Stillstand des Fahrzeuges erfolgt sind, ausgelöst werden.

Es war somit die Aufgabe gestellt, ein elektronisches Registriergerät der genannten Art derart in einem Kraftfahrzeug zu befestigen, daß mit möglichst einfachen Mitteln eine Entnahme des Registriergerätes nur dann möglich ist, wenn zuerst die elektrischen Verbindungen des Registriergerätes getrennt worden sind.

Die Lösung der Aufgabe geht, gemäß dem Oberbegriff des Anspruchs 1, von einer Vorrichtung aus, wie sie beispielsweise in der EP 538854 B1 beschrieben ist. Sie sieht vor, daß die Führung des Registriergerätes und die Steckerverbindung derart angeordnet sind, daß sich die Führungsrichtung und die Betätigungsrichtung der Steckerverbindung kreuzen und daß an dem Halter ein Sperrglied derart mit dem Stecker zusammenwirkend angebracht ist, daß das Sperrglied eine Entnahme des Registriergerätes bei gestecktem Stecker verhindert.

Der aufgabengemäß gestellten Forderung nach möglichst geringem Aufwand und einer Zwangsreihenfolge bei der Entnahme des Registriergerätes mit dem Ziel, daß die Stromversorgung unterbrochen ist, wenn das Registriergerät entnommen wird, wird die gefundene Lösung wirkungsvoll und ausfallsicher gerecht. Manipulationen sind auf einfache Weise, d. h. ohne Hilfsmittel, nachweisbar. Auch eine Vereinfachung bei der Montage des Registriergerätes wird erzielt, in dem nur der Stecker des Registriergerätes, der sozusagen als Verriegelung der Führung des Registriergerätes dient, plombiert werden muß. Eine Plombierung einer als Befestigungsmittel dienenden Schraube ist nicht erforderlich. Bei geeigneter Gestaltung der Führung ist es außerdem möglich, auf eine in vielen Einbausituationen nur umständlich zu betätigende Verschraubung, die lediglich dem Festhalten des Registriergerätes in der Führung dient, zu verzichten, in dem ein in geeignetes Weise gestalteter federnder Bügel verwendet wird. Denkbar ist ferner, daß im Zusammenwirken mit einer an dem Halter befestigten Blattfeder die Führung mit einer Kippfunktion versehen bzw. eine Rastverbindung zwischen dem Registriergerät und dem Halter geschaffen wird, so daß ein zusätzliches loses Teil zum Festhalten des Registriergerätes nicht erforderlich ist.

Im folgenden sei die Erfindung anhand der beigefügten Zeichnungen näher erläutert. Es zeigen
Fig. 1 eine Draufsicht auf eine beispielsweise auf dem Boden eines Fahrzeuges vorgesehene Befestigungsanordnung im Zustand der Entnahme des Registriergerätes,
Fig. 2 eine Seitenansicht der in Fig. 2 dargestellten Befestigungsanordnung im funktionsfertigen Zustand des Registriergerätes,
Fig. 3 eine weitere Seitenansicht der Befestigungsanordnung gemäß Fig. 1,
Fig. 4 eine Draufsicht einer Ausführungsvarianten der Befestigungsanordnung gemäß Fig. 1,
Fig. 5 eine Seitenansicht der Ausführungsvarianten gemäß Fig. 4.

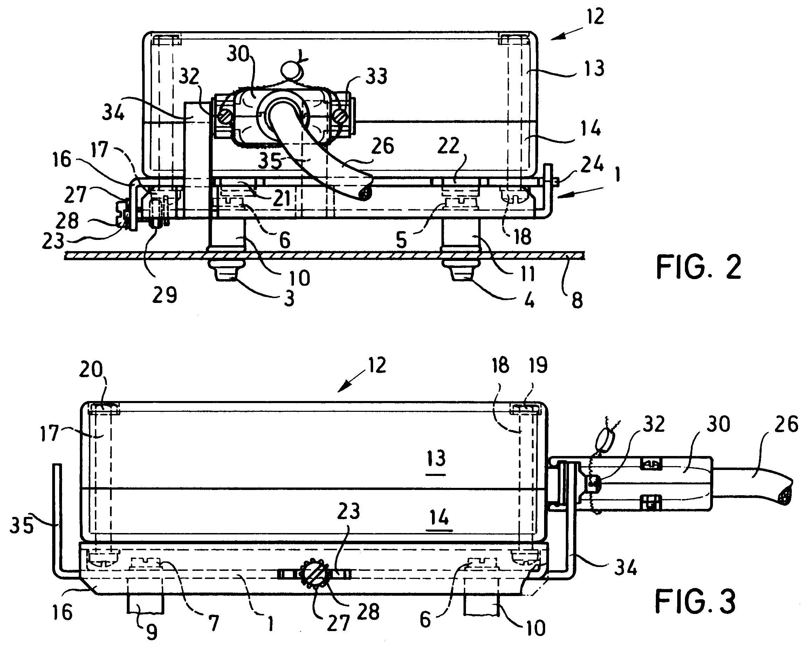

Die Befestigungsanordnung, wie sie in der EP-A-0 531 854 beschrieben ist, ist daraufhin optimiert, daß sie seriengerecht herstellbar ist und einen möglichst einfachen Ein- und Ausbau des Registriergerätes auch bei unebener Unterlage ermöglicht. Letztlich auch einen Selbsteinbau gestattet, wobei Rückwirkungen der Befestigungskräfte auf das Registriergerät weitgehend vermieden sind. Diese Befestigungsanordnung sieht einen Halter 1 vor, der gemäß Fig. 2 unter Verwendung von 3 oder 4 in geeigneter Weise abgedichteten Blindnietmuttern 2, 3 und 4 sowie diesen zugeordneten Schrauben 5, 6 und 7 auf dem Fahrzeugboden befestigt ist. Mit 9, 10 und 11 sind Distanzhülsen bezeichnet.

Bei dem dargestellten Ausführungsbeispiel besteht das Gehäuse 12 des elektronischen Registriergerätes aus zwei Gehäuseschalen 13 und 14, die über eine zentral angeordnete und mit einer Plombe 15 versehene Verschraubung miteinander verbunden sind. Dem Gehäuse 12 ist ein Träger 16 zugeordnet, welcher mittels Durchgangsschrauben 17 und 18, die mit in der Gehäuseschale 13 versenkt angeordneten Muttern 19 und 20 zusammenwirken, verschraubt ist. Der Träger 16 und der Halter 1 sind als Blechbiegeteile mit geeigneten nicht näher bezeichneten Wangen derart ausgebildet, daß sie miteinander verschachtelbar sind und ineinander geführt werden können. Hierzu dienen Schlitz-Zungen-Verbindungen und zwischen die Wangen am Halter 1 eingreifende am Träger 16 angeformte Finger, von denen in Fig. 2 zwei mit 21 und 22 bezeichnet sind. Mit 23 ist eine am Kalter 1 angeformte Zunge bezeichnet, die in einen am Träge 16 vorgesehenen Schlitz eingreift. Zwei weitere Zungen 24 und 25, die in nicht näher bezeichnete Schlitze im Halter 1 eingreifen, sind an dem Träger 16 ausgebildet. Der Vollständigkeit halber sei noch erwähnt, daß die am Träger 16 ausgebildeten Funktionselemente auch unmittelbar an der Gehäuseschale 14 angeformt sein können und damit der Träger 16 und dessen Montage eingespart werden könnte. Die Verwendung des Trägers 16 hat jedoch den Vorzug, daß durch die Verbindung des Registriergerätes mit dem Träger zwei Möglichkeiten bestehen, die einen entgegengesetzten Abgang des Kabels 26, in welchem die elektrischen Leitungen des Registriergerätes zusammengeefaßt sind, gestatten. Eine mit einer Zahnscheibe 27 versehene Schraube 28, die mit einer im Halter 1 gelagerten Schlitzmutter 29 zusammenwirkt, dient dem Fixieren von Halter 1 und Träger 16 in der zusammengefügten Stellung. Das auf diese Weise befestigte Registriergerät ist somit nur von seinem Einbauort entnehmbar, wenn es nach dem Lösen der Schraube 28, in der durch die Schlitz-Zungen-Verbindungen vorgegebenen Richtung (Pfeil B) bewegt wird. Dabei ist die Länge der Führung auf einfache Weise durch die Länge der Zungen bestimmbar.

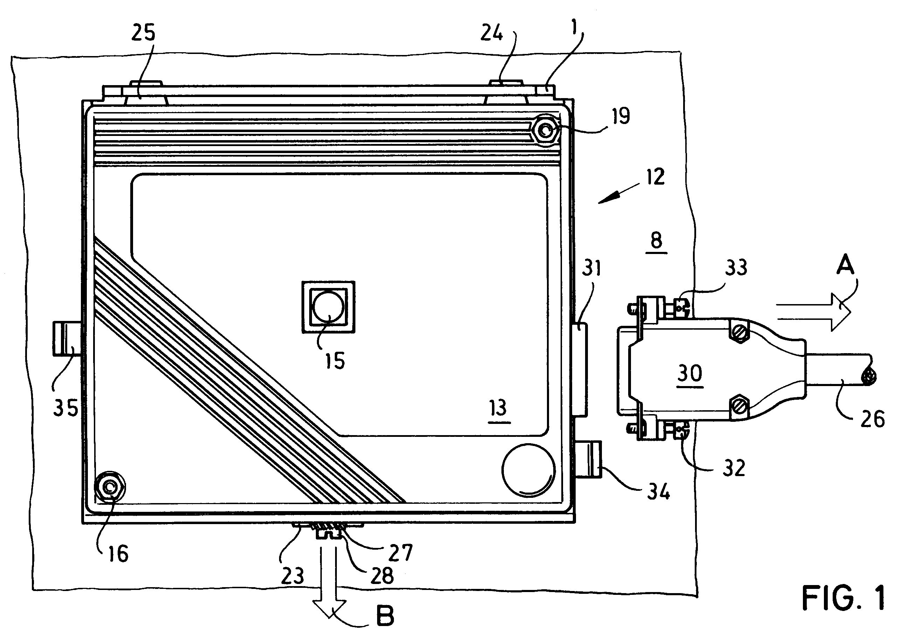

Wie ferner aus den Figuren ersichtlich ist, erfolgt der Anschluß des Kabels 26 an dem Registriergerät mittels eines Steckers 30, der mit dem zugeordneten im Registriergerät befestigten Steckersockel 31 zusätzlich mittels Schrauben 32 und 33 verschraubt ist. Für die Verschraubung des Steckers 30 werden zweckmäßigerweise Kreuzlochschrauben verwendet, so daß, was in den Figuren 1 bis 3 nicht dargestellt ist, nach dem Festschrauben des Steckers 30 eine gegenseitige Plombierung der Schrauben 32 und 33 mittels eines Plombendrahtes vorgenommen werden kann.

Die angestrebte Reihenfolge beim Ausbau des Registriergerätes wird nun auf einfachste Weise dadurch erzwungen, daß an dem Halter 1 entsprechend der beiden möglichen Abgänge des Kabels 26 fingerförmige Sperrglieder 34 und 35 derart angeformt sind, daß der Abstand zwischen einem gesetzten Stecker und dem jeweiligen Sperrglied 34 bzw. 35 relativ klein ist. Auf diese Weise kann das Registriergerät innerhalb der Führung nur verschoben werden, wenn der Stecker 30 in Pfeilrichtung A abgezogen worden ist. Dementsprechend ist für die Plombierung des Registriergerätes nur die Plombierung des Steckers 30 erforderlich, d. h. auf eine Plombierung der Schraube 28 kann verzichtet werden. Dadurch ist auch eine größere Wahlfreiheit bezüglich dieser Verschraubung oder einer anderen Art des Festhaltens des Registriergerätes in der durch die Zungen-Schlitz-Verbindungen gebildeten Führung gegeben. Beispielsweise kann des Festhalten des Registriergerätes in der Führung durch einen federnden Bügel bzw. eine federnde Klammer erfolgen, welche sich an der Frontwand des Trägers 16 oder am Registriergerät abstützt, wobei deren Enden jeweils in den Sperrgliedern 34 und 35 eingehängt sind. Die gefundene Lösung ist auch dann anwendbar, wenn ein Halter vorgesehen ist, in welchem eine senkrecht gerichtete Führung ausgebildet ist.

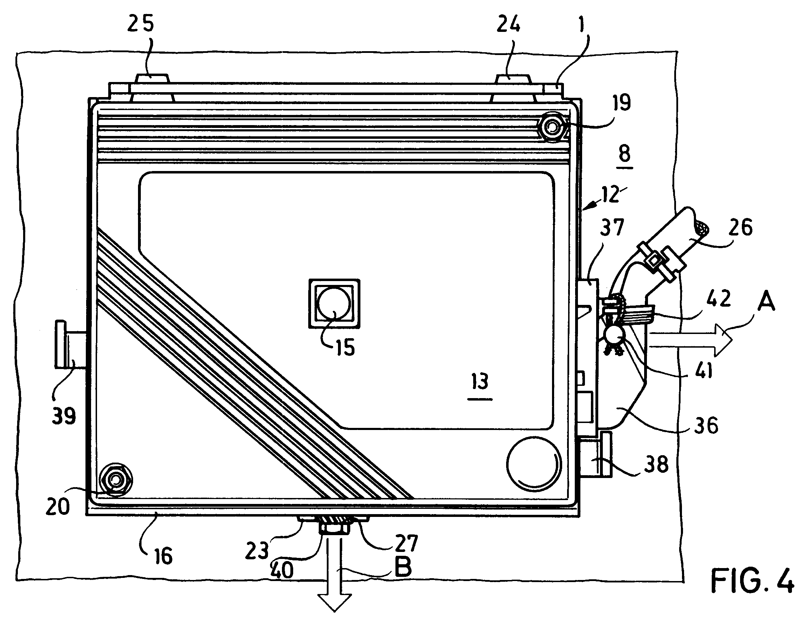

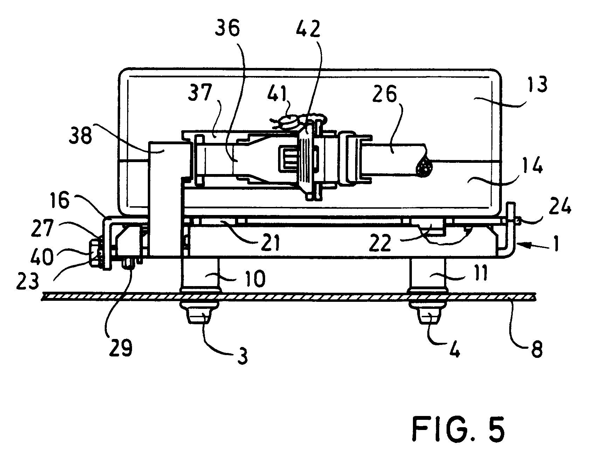

Die Ausführungsvariante gemäß den Fig. 4 und 5 zeigt im Gegensatz zu der in den Fig. 1 bis 3 beschriebenen Variante insbesondere die Verwendung eines Steckers 36, welcher in einem dem Stecker 36 zugeordneten Steckersockel 37 betrieblich arretiert wird. Dabei machen die Konturen des Steckers 36, um die Bewegungsmöglichkeit des Registriergerätes innerhalb der Führung gering zu halten, bei sonst völlig gleichen Bauformen, angepaßte Sperrglieder 38 und 39 erforderlich. Dem Festhalten des Registriergerätes in der Führung dient in diesem Falle eine Sechskantschraube 40, die je nach den Einbaugegebenheiten vorteilhafter zu betätigen ist als die Zylinderkopfschraube 28. Auf eine Plombierung der Sechskantschraube 40 kann verzichtet werden, da das Registriergerät unmittelbar über den Stecker 36 plombiert ist, wobei eine Drahtplombe 41 vorgesehen ist, die den Arretierhebel 42 des Steckers 36 mit dem Steckergehäuse verbindet.

Es sei nochmals betont, daß die gefundene Lösung sowohl eine Vereinfachung der Befestigung des Registriergerätes gestattet als auch die angestrebte Zwangsreihenfolge bei der Entnahme des Registriergerätes ermöglicht.

## Patentansprüche

1. Anordnung zum Befestigen eines elektronischen Registriergerätes mit Mitteln zum Verhindern der Entnahme des Registriergerätes bei nicht unterbrochener Stromversorgung, wobei die Stromversorgung des Registriergerätes über einen Stecker erfolgt, welcher mit einem im Registriergerät angeordneten und von außen zugänglichen Steckersockel verbindbar ist und zur Befestigung des Registriergerätes am Einbauort ein Halter vorgesehen ist, an welchem eine einem definierten Sitz des Registriergerätes dienende Führung ausgebildet ist,
dadurch gekennzeichnet,
daß die Führung des Registriergerätes und die Steckerverbindung derart angeordnet sind, daß sich die Führungsrichtung (B) und die Betätigungsrichtung (A) der Steckerverbindung kreuzen und daß wenigstens ein ortsfestangeordnetes Sperrglied (34, 38) derart mit dem Stecker zusammenwirkt, daß das Sperrglied (34, 38) ein Verschieben des Registriergerätes in der Führung bei gestecktem Stecker (30, 36) verhindert.

2. Anordnung nach Anspruch 1
dadurch gekennzeichnet,
daß das Sperrglied (34, 38) unmittelbar an dem Halter (1) angeformt ist.

3. Anordnung nach Anspruch 1
dadurch gekennzeichnet,
daß der Führung Rastmittel zugeordnet sind.

4. Anordnung nach Anspruch 1
dadurch gekennzeichnet,
daß zum wechselweisen Einsetzen des Registriergerätes in die Führung ein Sperrglied (34, 35 und 38, 39) vorgesehen ist.

5. Anordnung nach Anspruch 4
dadurch gekennzeichnet,
daß zum Festhalten des Registriergerätes in der Führung ein federnder Bügel vorgesehen ist, der unter Vorspannung an der einen Seitenwand des Registriergerätes anliegt und dessen Enden in den Sperrgliedern (34, 35 bzw. 38, 39) eingehängt sind.

## Claims

1. Arrangement for fixing an electronic recording device using means for preventing the removal of the recording device in the event of the power supply not having been interrupted, the power supply to the recording device taking place by way of a plug which is connectable to a plug socket arranged in the recording device and accessible from outside and for fixing the recording device at the mounting location there being provided a holder on which a guide is constructed which serves for defined seating of the recording device, characterised in that the guide of the recording device and the plug connection are arranged in such a way that the guiding direction (B) and the actuating direction (A) of the plug connection intersect and that at least one stationarily arranged blocking member (34, 38) cooperates with the plug in such a way that the blocking member (34, 38) prevents displacement of the recording device in the guide when the plug (30, 36) is in the plug socket.

2. Arrangement according to Claim 1, characterised in that the blocking member (34, 38) is integrally formed directly on the holder (1).

3. Arrangement according to Claim 1, characterised in that latching means are assigned to the guide.

4. Arrangement according to Claim 1, characterised in that for reversible insertion of the recording device into the guide there is provided a blocking member (34, 35 and 38, 39).

5. Arrangement according to Claim 4, characterised in that for securing the recording device in the guide there is provided a spring shackle which bears, under pretension, against one side wall of the recording device and the ends of which are hung in the blocking members (34, 35 and 38, 39 respectively).

## Revendications

1. Dispositif pour la fixation d'un appareil enregistreur électronique avec des moyens pour l'empêchement du prélèvement dudit appareil enregistreur en cas de non interruption de l'alimentation en courant, ladite alimentation en courant dudit appareil enregistreur étant assurée par l'intermédiaire d'un connecteur enfichable qui peut être relié à un socle de connexion disposé dans l'appareil enregistreur et accessible de l'extérieur et, pour la fixation dudit appareil enregistreur au lieu d'implantation, un appui étant prévu sur lequel est prévu un guidage servant à assurer une assise définie de l'appareil enregistreur,
caractérisé par le fait
que le guidage de l'appareil enregistreur et la connexion enfichable sont disposés de telle sorte que le sens de guidage (B) et le sens d'actionnement (A) de la connexion enfichable se croisent et qu'au moins un élément de blocage stationnaire (34, 38) coopère avec le connecteur enfichable de telle sorte que ledit élément de blocage (30, 38) empêche un déplacement dudit appareil enregistreur dans le guidage lorsque ledit connecteur (30, 36) est enfiché.

2. Dispositif selon la revendication 1,
caractérisé par le fait
que l'élément de blocage (34, 38) est formé directement sur l'appui (1).

3. Dispositif selon la revendication 1,
caractérisé par le fait
qu'au guidage sont associés des moyens d'arrêt.

4. Dispositif selon la revendication 1,
caractérisé par le fait
que pour la mise en place alternative de l'appareil enregistreur dans le guidage, il est prévu un élément de blocage (34, 35 et 38, 39).

5. Dispositif selon la revendication 4,
caractérisé par le fait
que pour la contention de l'appareil enregistreur dans le guidage, il est prévu un cintre élastique qui appuie, avec une précontrainte, sur l'une des parois latérales dudit appareil enregistreur et que les extrémités de ce dernier sont accrochées dans les éléments de blocage (34, 35 ou 38, 39).
